# EUROPÄISCHE PATENTSCHRIFT

(11) **EP 2 467 924 B1**
(45) Veröffentlichungstag und Bekanntmachung des Hinweises auf die Patenterteilung: **15.03.2017**
(21) Anmeldenummer: 10749602.8
(22) Anmeldetag: 19.08.2010
(51) Int. Cl.: H02K 35/02, H02N 1/08, H03H 9/02, H01L 41/09

(54) **FREQUENZABSTIMMBARER RESONATOR UND VERFAHREN ZUM BETREIBEN EINES SOLCHEN**
FREQUENCY-TUNABLE RESONATOR AND METHOD FOR OPERATING IT
RÉSONATEUR POUVANT ÊTRE SYNTONISÉ EN FRÉQUENCE ET PROCÉDÉ POUR LE FAIRE FONCTIONNER

(30) Priorität: 21.08.2009 DE 102009038306
(43) Veröffentlichungstag der Anmeldung: 27.06.2012
(73) Patentinhaber: Albert-Ludwigs-Universität Freiburg, 79098 Freiburg (DE)
(72) Erfinder: WISCHKE, Martin, 79098 Freiburg (DE); GOLDSCHMIDTBÖING, Frank, 79183 Waldkirch (DE); WOIAS, Peter, 79102 Freiburg (DE)
(74) Vertreter: Huwer, Andreas
(86) Internationale Anmeldenummer: PCT/EP2010/005088
(87) Internationale Veröffentlichungsnummer: WO 2011/020613

(56) Entgegenhaltungen:
- WO-A2-03/003478
- DE-A1-102007 003 280
- GB-A- 2 425 160
- US-A- 4 093 885
- US-A1- 2003 209 953
- US-B2- 7 471 033

## Beschreibung

Die Erfindung betrifft einen frequenzabstimmbaren Resonator nach dem Oberbegriff von Anspruch 1 und ein Verfahren zum Betreiben eines solchen Resonators. Unter einem Resonator wird eine Struktur verstanden, die durch eine mechanische Anregungsschwingung zu einer Resonanzschwingung angeregt werden kann, deren Amplitude die Amplitude der Anregungsschwingung übertrifft. Unter einem Biegebalken wird insbesondere ein Kragbalken verstanden, also ein passiver Balken, der an einem Ende an der Befestigungsstelle gelagert ist.

Ein derartiger Resonator ist aus US 7 471 033 B2 bekannt. Er weist einen mit einem Metallplättchen auf, das etwa die Form einer Blattfeder hat. Das Metallplättchen hat an seinem einen Ende eine Befestigungsstelle, die mit einem Widerlager fest verbunden ist. An seinem von der Befestigungsstelle entfernten anderen Ende hat das Metallplättchen eine Auslenkstelle, an der das Metallplättchen quer zu seiner Erstreckungsebene aus einer Neutrallage relativ zu der Widerlagerstelle auslenkbar ist. In der Neutrallage hat das Metallplättchen einen etwa ebenen, geraden Verlauf Die Auslenkung des Biegebalkens wird durch Vibrationen bewirkt, die über das Widerlager auf das Metallplättchen übertragen werden.

Auf dem Metallplättchen ist eine piezoelektrische Schicht angeordnet, die etwa parallel zur Erstreckungsebene des Metallplättchens verläuft und flächig mit einem ihr zugewandten Oberflächenbereich des Metallplättchens verbunden ist. An die piezoelektrische Schicht ist mit Hilfe einer Ansteuereinrichtung ein elektrisches Feld anlegbar, das den Biegebalken derart mechanisch verspannt, dass er einen von der Neutrallage abweichenden, gekrümmten Verlauf aufweist. Diese Verkrümmung bewirkt eine Veränderung der Resonanzfrequenz des Biegebalkens. Dadurch ist es möglich, die Resonanzfrequenz des Resonators an die Frequenz der auf den Resonator einwirkenden Vibrationen anzupassen.

An der Auslenkstelle ist an dem Biegebalken ein Permanentmagnet befestigt, der sich beim Auslenken des Biegebalkens auf eine Induktionsspule zu bzw. von dieser wegbewegt. Dabei wird in der Induktionsspule eine elektrische Spannung induziert, mit der eine elektronische Schaltung betrieben wird.

Der in US 7 471 033 B2 beschriebene Resonator hat den Nachteil, dass seine Resonanzfrequenz nur in einem relativ kleinen Bereich verstellbar ist. Ungünstig ist außerdem, dass der Biegebalkens bei an der piezoelektrischen Schicht anliegendem elektrischen Feld asymmetrisch schwingt. Dadurch kann die in den Vibrationen enthaltene mechanische Energie nicht optimal in elektrische Energie umgewandelt werden.

Aus US 2003/0209953 A1 ist ferner ein Resonator mit einem Biegebalkens bekannt, der eine Befestigungsstelle und eine davon beabstandete Auslenkstelle aufweist. Der Biegebalken ist an der Befestigungsstelle derart mit wenigstens einem Widerlager verbunden, dass die Auslenkstelle in einer quer zur Längserstreckung des Biegebalkens angeordneten Auslenkrichtung unter Biegeverformung des Biegebalkens relativ zu der mindestens einen Befestigungsstelle bewegbar ist. Der Biegebalken weist eine quer zur Auslenkrichtung angeordnete erste piezoelektrische Schicht und eine etwa parallel dazu angeordnete zweite piezoelektrische Schicht auf, die derart mechanisch mit der ersten Schicht verbunden ist, dass sich die Schichten beim Auslenken der Auslenkstelle gegeneinander verspannen. Zum Anlegen von elektrischen Feldern an die Schichten weist der Resonator eine Ansteuereinrichtung auf

Der Resonator dient als Dämpfer zur Unterdrückung von Multimode-Vibrationen. Zur Erzeugung von die Vibrationen dämpfenden Rückstellmomenten werden an die beiden piezoelektrischen Schichten unterschiedliche elektrische Signale angelegt. Mit Hilfe der an die erste Schicht angelegten Signale werden Schwingungsamplituden mit niedriger Frequenz und mit Hilfe der an die zweite Schicht angelegten Signale werden Schwingungsamplituden mit hoher Frequenz gedämpft.

Aus GB 2 425 160 A ist eine gattungsfremde Vorrichtung zum Erzeugen von elektrischer Energie aus einer Anregungsschwingung bekannt.

In der WO 03/003478 A2 wird ein piezoelektrischer Biegewandler beschrieben, der einen Schichtstapel mit mehreren piezoelektrischen Schichten aufweist. Diese sollen so gegeneinander verspannt werden, dass sich die Schichten durchbiegen und ein vertikaler Hub des Biegewandlers erzeugt wird. Um Spannungsspitzen im Schichtstapel zu vermeiden, sind die Höhen der einzelnen Schichten entsprechend angepasst.

In DE 10 2007 003 280 A1 ist ein Piezoaktor beschrieben, der einen Stapelaufbau aufweist. Dieser Aktor besteht aus zwei Multilagenaktoren, die nebeneinander in einem Schichtstapel ausgebildet sind. Die beiden Einzelaktoren sind somit aus denselben Piezoschichten gebildet, die Elektroden zwischen den Schichten sind jedoch teilweise segmentiert. Dadurch können an beide Teilaktoren unterschiedliche Steuerspannungen angelegt werden, um entsprechend unterschiedliche Biegeverformungen zu erzeugen.

Aus US 4 093 885 A ist ein ferner ein Piezo-Bimorphaktor bekannt, der durch Segmentierung von Elektroden so aufgeteilt ist, dass ein erster Teil der Piezokeramik als Aktor wirkt, während ein zweiter Teil als ladungsliefernder Sensor wirkt. Es werden Biegeverformungen des Bimorph erzeugt und deren Maß wird mit Hilfe der integrierten Sensoren detektiert.

Aufgabe der Erfindung ist es, einen frequenzabstimmbaren Resonator der eingangs genannten Art zu schaffen, dessen Resonanzfrequenz in einem relativ großen Frequenzbereich einstellbar ist. Außerdem besteht die Aufgabe, ein Verfahren zum Betreiben eines frequenzabstimmbaren Resonators zu schaffen, bei dem die Resonanzfrequenz in einem weiten Bereich energiesparend verstellt werden kann.

Bezüglich des Resonators wird diese Aufgabe mit den im Anspruch 1 angegebenen Merkmalen gelöst. Mit Hilfe der Ansteuereinrichtung sind derart elektrische Felder an die Schichten anlegbar, dass an den Schichten piezoelektrisch Kräfte erzeugt werden, deren Wirkung entgegengesetzt ist. Die Kräfte erzeugen Biegemomente, die in zueinander entgegen gesetzte Richtungen gerichtet sind und sich kompensieren.

Die Wirkungen dieser Kräfte und der daraus resultierenden Biegemomente kompensieren sich bevorzugt vollständig, so dass der in Neutrallage befindliche Biegebalken durch das Anlegen der elektrischen Felder nicht ausgelenkt wird. Der Biegebalkens kann dadurch sowohl bei angelegtem elektrischem Feld als auch bei nicht angelegtem elektrischem Feld jeweils symmetrisch um seine Neutrallage schwingen. Die von den elektrischen Feldern auf die piezoelektrischen Schichten ausgeübten Kräfte können je nach Polarität der Felder und je nach Polarisierung der Schichten aufeinander zu oder voneinander weg weisen, sich in Summe aber immer kompensieren. Die piezoelektischen Schichten bewirken beim Anlegen der elektrischen Felder eine Änderung der Steifigkeit des Biegebalkens. Zwischen den piezoelektrischen Schichten kann eine elastische Schicht sein, beispielsweise eine Klebstoffschicht, welche die Schichten flächig miteinander verbindet. Die einzelnen piezoelektrischen Schichten werden erst nach ihrer Herstellung durch eine Verbindungstechnik, z.B. Piezopolymer, zu einem Schichtstapel miteinander verbunden.

Bei einer bevorzugten Ausgestaltung der Erfindung sind die piezoelektrischen Schichten in zueinander entgegen gesetzte Richtungen polarisiert und die Ansteuereinrichtung ist derart ausgestaltet, dass das elektrische Feld in der ersten Schicht in die entgegen gesetzte Richtung weist wie das elektrische Feld in der zweiten Schicht. Das elektrische Feld kann dabei zwischen Elektrodenschichten erzeugt werden, die auf die piezoelektrischen Schichten aufgebracht sind.

Bei einer anderen vorteilhaften Ausgestaltung der Erfindung sind die piezoelektrischen Schichten in dieselbe Richtung polarisiert, wobei die Ansteuereinrichtung derart ausgestaltet ist, dass das elektrische Feld in der ersten Schicht in dieselbe Richtung weist wie das elektrische Feld in der zweiten Schicht. Dabei können die Feldstärkevektoren der elektrischen Felder aufeinander zu oder voneinander weg weisen. Auch die Vektoren der elektrischen Polarisierung der piezoelektrischen Schichten können aufeinander zu oder voneinander weg weisen.

Bei einer Weiterbildung der Erfindung weist die Ansteuereinrichtung ein Verstelleinrichtung zum Verstellen der Feldstärke der elektrischen Felder auf Die Steifigkeit des Kragbalkens und damit die Resonanzfrequenz des Resonators kann dann durch dass Anlegen unterschiedlich starker elektrischer Felder vergrößert oder verkleinert werden. Bei Bedarf kann die Resonanzfrequenz also in beide Richtungen verstellt werden.

Vorteilhaft ist, wenn der Biegebalken zumindest einen ersten Abschnitt und einen zweiten Abschnitt aufweist, die in Längserstreckungsrichtung des Biegebalkens hintereinander angeordnet sind, wobei die piezoelektrischen Schichten nur in dem ersten Abschnitt angeordnet sind, und wobei der zweite Abschnitt vorzugsweise etwa die gleiche Biegesteifigkeit aufweist, wie der erste Abschnitt. Der erste Abschnitt ist dabei näher an der Befestigungsstelle angeordnet als der zweite Abschnitt. Dadurch kann mit einem kurzen und kostengünstigen Piezoelement die Resonanz-frequenz in einem relativ breiten Frequenzband verstellt werden. Durch die kompakten Abmessungen der piezoelektrischen Schicht reduziert sich außerdem die elektrische Energieaufnahme der piezoelektrischen Schicht beim Verstellen der Resonanzfrequenz. Der zweite Abschnitt des Biegebalkens dient im Wesentlichen dazu, die Länge des Biegebalkens und damit die Resonanzfrequenz des Resonators festzulegen. Der zweite Abschnitt des Biegebalkens ist mit seiner Haupterstreckungsrichtung bevorzugt in Längserstreckungsrichtung des Biegebalkens orientiert. Dabei ist die Abmessung des zweiten Abschnitts In Auslenkungsrichtung des Biegebalkens kleiner als in Längserstreckungsrichtung des Biegebalkens.

Bei einer bevorzugten Ausführungsform der Erfindung weist die Ansteuereinrichtung eine Impulsvorrichtung zum Erzeugen eines zeitlich begrenzten elektrischen Feldimpulses auf Überraschenderweise ändert sich die Resonanzfrequenz des Resonators nach dem Entfernen des elektrischen Felds nur relativ langsam auf den Wert, den sie hat, wenn über eine lange Zeitdauer kein elektrisches Feld an die piezoelektischen Schichten angelegt wurde. Es ist daher ausreichend, das elektrische Feld nur in Form eines kurzen Pulses an die piezoelektrische Schicht anzulegen. Auf den Puls kann dann eine Pulspause folgen, deren Dauer beispielsweise in Abhängigkeit von der Geschwindigkeit gewählt werden kann, mit der sich die Resonanzfrequenz nach dem Entfernen des elektrischen Felds verändert. Bei Bedarf kann ggf mindestens ein weiterer, eine Pulsphase und eine Pulspause aufweisender Ansteuerzyklus durchgeführt werden. In vorteilhafter Weise kann durch das Pulsen des elektrischen Felds die für das Einstellen der Resonanzfrequenz benötigte elektrische Energie erheblich reduziert werden.

Der erfindungsgemäße frequenzabstimmbare Resonator kann ein Teil einer Vorrichtung zum Erzeugen von elektrischer Energie aus einer mechanischen Anregungsschwingung sein, die einen mit dem Biegebalken in Antriebsverbindung stehenden elektrischen Generator aufweiset. Der Generator kann nach dem Induktionsprinzip arbeiten und beispielsweise einen mit der Auslenkstelle verbundenen Permanentmagneten aufweisen, in dessen Magnetfeld eine zu der Befestigungsstelle ortsfeste Spule angeordnet ist. Selbstverständlich ist auch eine umgekehrte Anordnung denkbar, bei der die Spule an der auslenkbaren Stelle des Biegebalkens und der Permanentmagnet ortsfest angeordnet sind. Der Generator kann auch einen Kondensator mit aufeinanderzu- und voneinander wegbewegbaren Elektroden aufweisen, die mit Hilfe des Biegebalkens relativ zueinander bewegt werden, um die elektrische Kapazität des Kondensators zu verändern. Es ist auch denkbar, dass der Generator ein Piezoelement aufweist, mittels dem die mechanische Schwingungsenergie unter Ausnutzung des Piezoeffekts in eine elektrische Spannung umgeformt wird.

Vorteilhaft ist, wenn die Ansteuereinrichtung einen Steuereingang zum Anlegen eines die Resonanzfrequenz des Resonators beeinflussenden Steuersignals hat, wobei die Vorrichtung einen Sensor zur Erfassung der von dem Generator abgegebenen elektrischen Leistung und/oder der Auslenkung des Biegebalken aufweist, und wobei der Sensor über einen Regler derart mit dem Steuereingang in einen Regelkreis geschaltet ist, dass die Vorrichtung in einem Arbeitspunkt betrieben wird, an dem die von dem Generator abgegebene elektrische Leistung ein lokales Maximum aufweist. Die Vorrichtung ermöglicht dann bei der Umformung der Schwingungs- bzw. Vibrationsenergie in elektrische Energie einen besonders hohen Wirkungsgrad.

Bezüglich des Verfahrens wird die vorstehend genannte Aufgabe mit den Merkmalen des Anspruchs 9 gelöst.

Bei einer bevorzugten Ausführungsform des Verfahrens werden Spannungsimpulse an beidseits der piezoelektrischen Schichten angeordnete Elektrodenschichten angelegt. Dadurch kann die Resonanzfrequenz des Resonators energiesparend verstellt werden.

Bei dem erfindungsgemäßen Verfahren wird der Resonator bevorzugt zu mechanischen Schwingungen angeregt und die Schwingungsenergie des Biegebalkens wird in elektrische Energie umgeformt. Die elektrische Energie wird gespeichert und damit kann dann beispielsweise eine elektrische Schaltung oder ein elektrischer Verbraucher autark betrieben werden.

Nachfolgend sind Ausführungsbeispiele der Erfindung näher erläutert. Es zeigt:
- Fig. 1: eine Seitenansicht eines ersten Ausführungsbeispiels einer Vorrichtung zum Erzeugen von elektrischer Energie aus einer mechanischen Anregungsschwingung,
- Fig. 2: eine Seitenansicht eines zweiten Ausführungsbeispiels der Vorrichtung,
- Fig. 3: eine Seitenansicht eines dritten Ausführungsbeispiels der Vorrichtung,
- Fig. 4: eine grafische Darstellung der Resonanzfrequenz eines einen Biegebalken mit zwei piezoelektrischen Schichten aufweisenden Resonators nach dem Entfernen eines elektrischen Felds von den Schichten, wobei auf der Abszisse die seit dem Entfernen des Felds verstrichene Zeit, auf der Ordinate die Resonanzfrequenz und als Parameter die an den Schichten anliegende elektrische Spannung in Volt aufgetragen sind, und
- Fig. 5: eine grafische Darstellung der elektrischen Ausgangsleistung eines an den Biegebalken angehängten Energieerzeugungs-Generators in Abhängigkeit von der Frequenz der Anregungsschwingung bei Anpassung der Resonanzfrequenz des Resonators, wobei auf der Abszisse die Anregungsschwingung und auf der Ordinate die Ausgangsleistung aufgetragen sind.

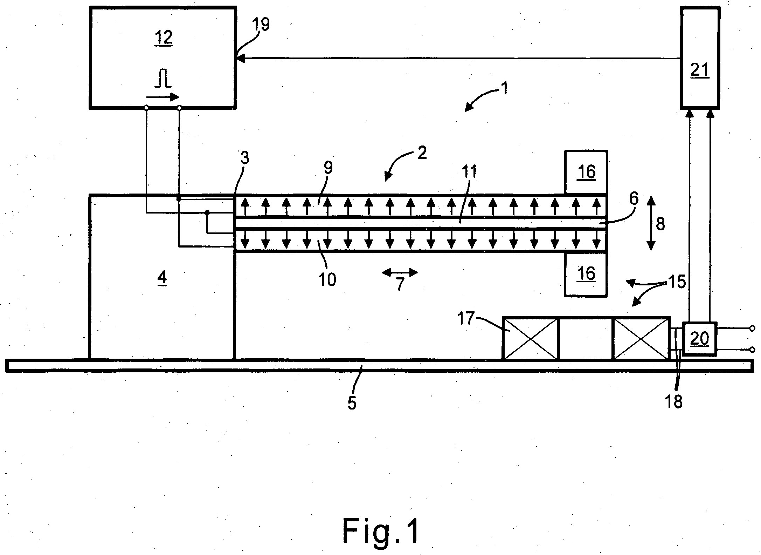

Ein in Fig. 1 im Ganzen mit 1 bezeichneter frequenzabstimmbarer Resonator weist einen Biegebalken 2 auf, der an seinem einen Endbereich eine Befestigungsstelle 3 hat, an der er an einem Widerlager 4 eingespannt ist. Das Widerlager 4 ist an einem Basisteil 5 angeordnet, an dem mechanische Schwingungen oder Vibrationen auftreten. Die Schwingungen oder Vibrationen können beispielsweise von einem Antriebsmotor einer Maschine erzeugt werden.

An einem von der Befestigungsstelle 3 entfernten Endbereich hat der Biegebalken 2 eine Auslenkstelle 6, die unter Biegeverformung des Biegebalkens 2 quer zur Längserstreckung 7 des Biegebalkens 2 aus einer in Fig. 1 gezeigten Neutrallage relativ zu der Befestigungsstelle 3 in eine Auslenkrichtung 8 bewegbar ist.

Der Biegebalken 2 weist zwei etwa parallel zueinander verlaufende piezoelektrische Schichten 9, 10 auf, die sich in der Neutrallage des Biegebalkens 2 in Ebenen erstrecken, die normal zur Auslenkrichtung 8 angeordnet sind. Zwischen den piezoelektrischen Schichten 9, 10 ist eine elastische Lage 11 angeordnet, welche die Schichten 9, 10 flächig miteinander verbindet. Die elastische Lage 11 kann ein- oder mehrlagig sein und beispielsweise ein oder mehrere Klebstoffschichten enthalten. Sie ist derart mit den Schichten 9, 10 verbunden, dass diese in Längserstreckung 7 des Biegebalkens 2 einen Schichtverbund bilden. Wenn der Biegebalken 2 an der Auslenkstelle 6 aus der Neutrallage in Auslenkrichtung 8 ausgelenkt wird, wird die eine Schicht 9, 10 in Längserstreckungsrichtung 7 komprimiert und die andere Schicht 10, 9 in Längserstreckung 7 gedehnt.

Beidseits der Schichten 9, 10 sind in der Zeichnung nicht näher dargestellte Elektroden angeordnet, die zum Anlegen von elektrischen Feldern an die Schichten 9, 10 mit einer Ansteuereinrichtung 12 verbunden sind. An eine erste piezoelektrische Schicht 9 ist ein erstes elektrisches Feld und an eine zweite piezoelektrische Schicht 9 ein zweites elektrisches Feld anlegbar.

Bei dem in Fig. 1 gezeigten Ausführungsbeispiel sind die Feldstärkevektoren des ersten und zweiten elektrischen Felds in zueinander entgegen gesetzte Richtungen ausgerichtet und die Schichten 9, 10 sind in zueinander entgegen gesetzte Richtungen polarisiert. Die Polarisationsrichtung ist in Fig. 1 durch Pfeile angedeutet. Beim Anlegend der elektrischen Felder an die Schichten 9, 10 wird von dem ersten elektrischen Feld auf die erste Schicht 9 eine erste Kraft und von dem zweiten elektrischen Feld auf die zweite Schicht 10 eine zweite Kraft ausgeübt. Die Feldstärken der Felder werden so eingestellt, dass die zweite Kraft der ersten Kraft entgegengesetzt ist und diese kompensiert, ohne dass es zu einer Auslenkung des Biegebalkens 2 kommt. Durch die Elastostriktion der piezoelektrischen Schichten im Biegebalkens 2 ändert sich die Steifigkeit des Biegebalkens 2. Somit kann die Resonanzfrequenz des Resonators 1 durch Anlegen unterschiedlich starker elektrischer Felder an die Schichten 9, 10 eingestellt werden.

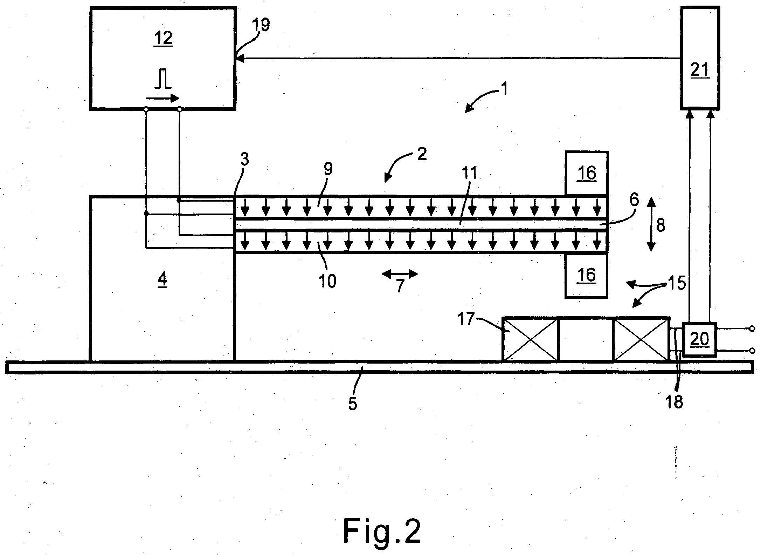

Bei dem in Fig. 2 gezeigten Ausführungsbeispiel sind die Feldstärkevektoren des ersten und zweiten elektrischen Felds in dieselbe Richtung ausgerichtet und die Schichten 9, 10 sind in dieselbe Richtung polarisiert. Beim Anlegen der elektrischen Felder an die Schichten 9, 10 kommt es zu einer Schichtverspannung ohne eine Auslenkung des Biegebalkens 2.

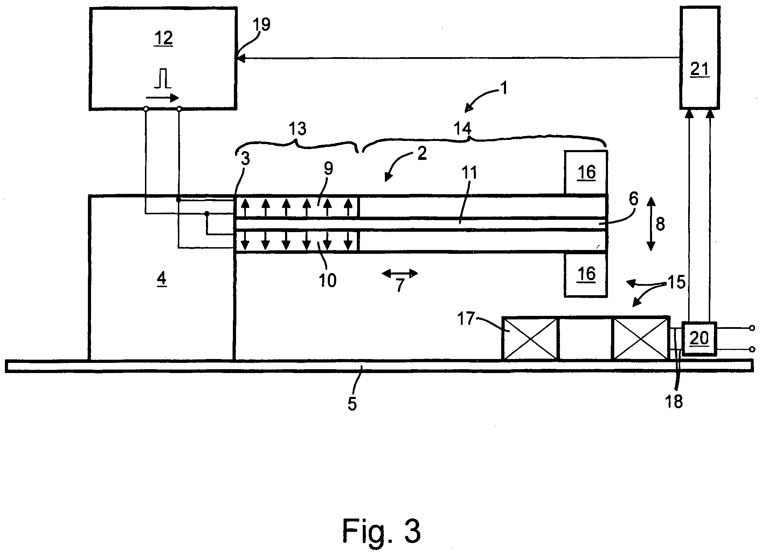

Bei dem in Fig. 3 gezeigten Ausführungsbeispiel weist der Biegebalken 2 einen ersten Abschnitt 13 und einen zweiten Abschnitt 14 auf, der bei in Neutrallage befindlichem Biegebalken 2 in gerader Verlängerung des ersten Abschnitts 13 angeordnet ist. Der erste Abschnitt 14 grenzt an die Befestigungsstelle 3 und der zweite Abschnitt 14 an die Auslenkstelle 6 an. Deutlich ist erkennbar, dass die piezoelektrischen Schichten 9, 10 nur in dem ersten Abschnitt 13 angeordnet sind. Der zweite Abschnitt 14 weist etwa die gleiche Biegesteifigkeit auf wie der erste Abschnitt 13. Die Länge des ersten Abschnitts 13 beträgt bevorzugt etwa zwischen einem Drittel und der Hälfte der Gesamtlänge des Biegebalkens 2. Da sich die piezoelektrischen Schichten 9, 10 nicht über die gesamte Länge des Biegebalken 2 erstrecken, wird für das Anlegen der elektrischen Felder an die Schichten 9, 10 bzw. für das Verändern der Felder nur eine entsprechend geringe elektrische Energie benötigt. Obwohl die Schichten 9, 10 in Längserstreckungsrichtung des Biegebalkens 2 nur relativ kleine Abmessungen haben, wird durch den zweiten Abschnitt 14 eine niedrige Resonanzfrequenz des Resonators 1 ermöglicht.

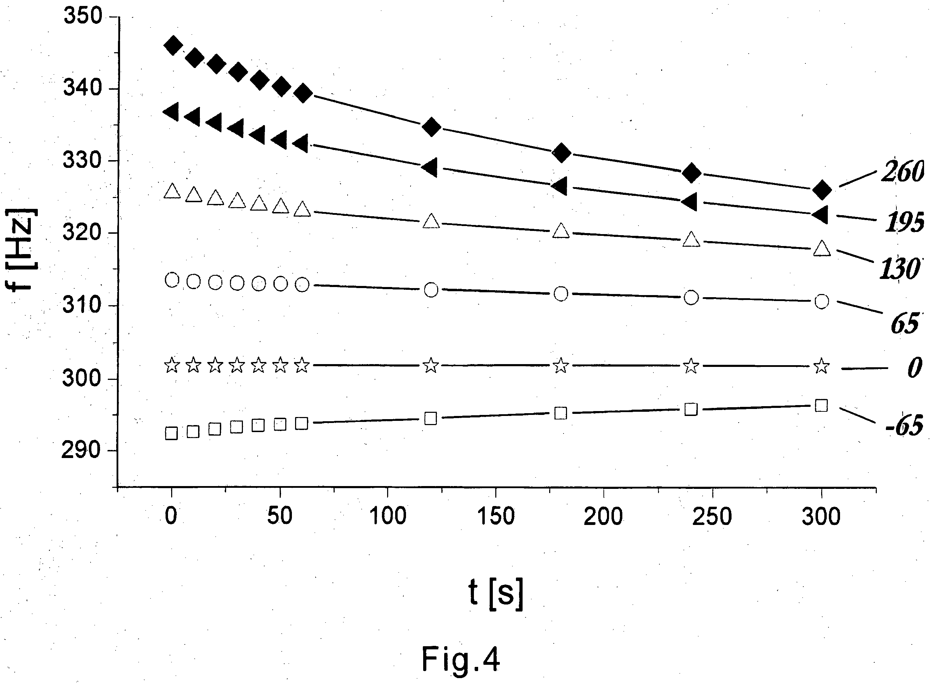

Zum Pulsen des elektrischen Felds weist die Ansteuereinrichtung 12 eine in der Zeichnung nicht näher dargestellte Impulsvorrichtung auf Mit Hilfe der Imulsvorrichtung wird jeweils für eine vorbestimmte Zeitdauer ein kurzer Spannungsimpuls an die Elektrodenschichten angelegt. Danach folgt eine Pause, in welcher der Stromfluss zwischen den Elektrodenschichten und der Ansteuereinrichtung 12 unterbrochen ist. Bei Bedarf kann nach Beendigung der Pause in entsprechender Weise mindestens ein weiterer Ansteuerzyklus durchgeführt werden. In Fig. 4 ist erkennbar, dass sich die Resonanzfrequenz des Resonators 1 während der Pause nur langsam verändert. Wenn die Pausen kurz eingestellt werden, beispielsweise unter 30 Sekunden, tritt während der Pausen keine wesentliche Veränderung der Resonanzfrequenz des Resonators 1 auf Durch die Impulse kann die für das Einstellen der Resonanzfrequenz benötigte elektrische Energie erheblich reduziert werden.

In Fig. 1 bis 3 ist erkennbar, dass die Auslenkstelle 6 des Biegebalkens 2 zum Erzeugen von elektrischer Energie aus den von dem Basisteil 5 auf den Resonator 1 übertragenen mechanischen Schwingungen mit einem elektrischen Generator 15 in Antriebsverbindung steht. Der Generator 15 weist einen mit der Auslenkstelle 6 verbundenen Permanentmagnet 16 auf, in dessen Magnetfeld eine Induktionsspule 17 angeordnet ist, die an dem Basisteil 5 angeordnet ist. Beim Schwingen des Biegebalkens 2 schwingt der Permanentmagnet 16 zusammen mit dem Biegebalken 2 relativ zu der Induktionsspule 17, wodurch sich die magnetische Flussdichte in der Induktionsspule 17 ändert. Dabei wird eine elektrische Spannung in der Induktionsspule 17 induziert, die an den Spulenanschlüssen 18 abgreifbar ist. An den Spulenanschlüssen 18 ist ein in der Zeichnung nicht näher dargestellter Pufferspeicher, wie z.B. ein Akku oder ein Kondensator, und/oder ein elektrischer Verbraucher angeschlossen.

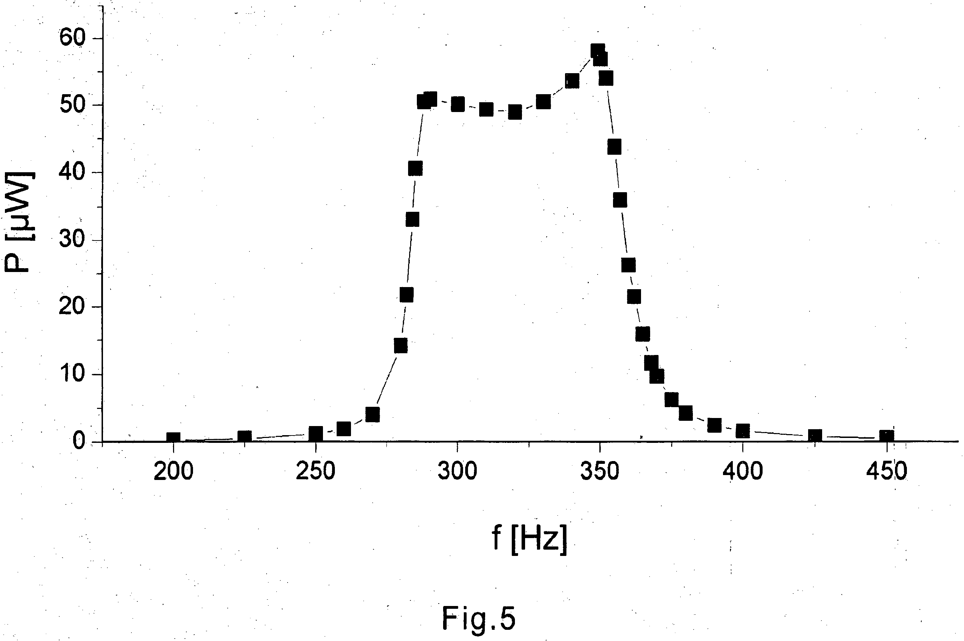

Zwischen den Spulenanschlüssen 18 und dem elektrischer Verbraucher und/oder Pufferspeicher ist ein Sensor 20 zur Erfassung der von dem Generator 15 abgegebenen elektrischen Leistung angeordnet. Ein Ausgang des Sensors 20 ist über einen Regler 21 mit einem Steuereingang 19 der Ansteuereinrichtung verbunden. Durch Anlegen eines elektrischen Steuersignals an den Steuereingang 19 kann die Feldstärke der elektrischen Felder zwischen den Elektrodenschichten und somit die Resonanzfrequenz des Resonators 1 eingestellt werden. Der Regler 21 ist derart ausgestaltet, dass die Resonanzfrequenz jeweils so eingestellt wird, dass die vom Generator 15 abgegebene Leistung ein Maximum aufweist. In Fig. 5 ist erkennbar, dass-die von dem Generator abgegebene elektrische Leistung P in einem Frequenzintervall zwischen 270 und 360 Hz in etwa konstant ist.

## Patentansprüche

1. Frequenzabstimmbarer Resonator (1), mit einem Biegebalken (2), der mindestens eine Befestigungsstelle (3) und wenigstens eine davon beabstandete Auslenkstelle (6) aufweist, wobei der Biegebalkens (2) an der mindestens einen Befestigungsstelle (3) derart mit wenigstens einem Widerlager (4) verbunden ist, dass die Auslenkstelle (6) in einer quer zur Längserstreckung (7) des Biegebalkens (2) angeordneten Auslenkrichtung (8) unter Biegeverformung des Biegebalkens (2) relativ zu der mindestens einen Befestigungsstelle (3) bewegbar ist, wobei der Biegebalken (2) eine quer zur Auslenkrichtung (8) angeordnete piezoelektrische Schicht (9) aufweist, und wobei der Resonator (1) eine Ansteuereinrichtung (12) zum Anlegen eines elektrischen Felds an die Schicht (9) aufweist, **dadurch gekennzeichnet, dass** der Biegebalken (2) zusätzlich zu der ersten Schicht (9) zumindest eine etwa parallel dazu angeordnete zweite piezoelektrische Schicht (10) aufweist, die derart mechanisch mit der ersten Schicht (9) verbunden ist, dass sich die Schichten (9, 10) beim Auslenken der Auslenkstelle (6) gegeneinander verspannen, und dass mit Hilfe der Ansteuereinrichtung (12) derart elektrische Felder an die Schichten (9, 10) anlegbar sind, dass an den Schichten (9, 10) piezoelektrisch Kräfte erzeugt werden, deren Wirkungen als sich kompensierende Biegemomente in zueinander entgegen gesetzte Richtungen weisen und auf die Schichten (9, 10) eine mechanische Vorspannung ausüben und der in Neutrallage befindliche Biegebalken durch das Anlegen der elektrischen Felder nicht ausgelenkt wird.

2. Frequenzabstimmbarer Resonator (1) nach Anspruch 1, **dadurch gekennzeichnet, dass** die piezoelektrischen Schichten (9, 10) in zueinander entgegen gesetzte Richtungen polarisiert sind und dass die Ansteuereinrichtung (12) derart ausgestaltet ist, dass das elektrische Feld in der ersten Schicht (9) in die entgegen gesetzte Richtung weist wie das elektrische Feld in der zweiten Schicht (10).

3. Frequenzabstimmbarer Resonator (1) nach Anspruch 1, **dadurch gekennzeichnet, dass** die piezoelektrischen Schichten (9, 10) in dieselbe Richtung polarisiert sind und dass die Ansteuereinrichtung (12) derart ausgestaltet ist, dass das elektrische Feld in der ersten Schicht (9) in dieselbe Richtung weist wie das elektrische Feld in der zweiten Schicht (10).

4. Frequenzabstimmbarer Resonator (1) nach einem der Ansprüche 1 bis 3, **dadurch gekennzeichnet, dass** die Ansteuereinrichtung (12) eine Verstelleinrichtung zum Verstellen der Feldstärke der elektrischen Felder aufweist.

5. Frequenzabstimmbarer Resonator (1) nach einem der Ansprüche 1 bis 4, **dadurch gekennzeichnet, dass** der Biegebalken (2) zumindest einen ersten Abschnitt (13) und einen zweiten Abschnitt (14) aufweist, die in Längserstreckungsrichtung (7) des Biegebalkens (2) hintereinander angeordnet sind, dass die piezoelektrischen Schichten (9, 10) nur in dem ersten Abschnitt (1 3) angeordnet sind, und dass der zweite Abschnitt (14) vorzugsweise etwa die gleiche Biegesteifigkeit aufweist, wie der erste Abschnitt (1 3).

6. Frequenzabstimmbarer Resonator (1) nach einem der Ansprüche 1 bis 5, **dadurch gekennzeichnet, dass** die Ansteuereinrichtung (12) eine Impulsvorrichtung zum Erzeugen eines gepulsten elektrischen Felds aufweist.

7. Vorrichtung zum Erzeugen von elektrischer Energie aus einer mechanischen Anregungsschwingung, mit einem frequenzabstimmbaren Resonator (1) nach einem der Ansprüche 1 bis 5 und mit einem mit dem Biegebalken (2) in Antriebsverbindung stehenden elektrischen Generator (15).

8. Vorrichtung nach Anspruch 7, wobei die Ansteuereinrichtung (12) einen Steuereingang (19) zum Anlegen eines die Resonanzfrequenz des Resonators (1) beeinflussenden Steuersignals hat, wobei die Vorrichtung einen Sensor (20) zur Erfassung der von dem Generator (15) abgegebenen elektrischen Leistung und/oder der Auslenkung des Biegebalkens (2) aufweist, und wobei der Sensor (20) über einen Regler (21) derart mit dem Steuereingang (19) in einen Regelkreis geschaltet ist, dass die Vorrichtung in einem Arbeitspunkt betrieben wird, an dem die von dem Generator (15) abgegebene elektrische Leistung ein lokales Maximum aufweist.

9. Verfahren zum Betreiben eines frequenzabstimmbaren Resonators (1), wobei ein Biegebalkens (2) bereitgestellt wird, der mindestens zwei etwa parallel zueinander verlaufende piezoelektrische Schichten (9, 10) aufweist, die mechanisch miteinander verbunden sind, wobei der Biegebalken (2) an mindestens einer Befestigungsstelle (3) gegen eine Widerlagerstelle abgestützt und an einer von der Befestigungsstelle (3) beabstandete Auslenkstelle (6) relativ zu der Befestigungsstelle (3) quer zu den Ebenen der piezoelektrischen Schichten (9, 10) derart in Schwingung versetzt wird, dass sich die Schichten (9, 10) gegeneinander verspannen, dass an die piezoelektrischen Schichten (9, 10) elektrische Felder angelegt werden, die derart ausgerichtet und bezüglich ihrer Feldstärker eingestellt sind, dass sie auf die Schichten (9, 10) mechanische Kräfte ausüben, deren Wirkungen als sich kompensierende Biegemomente in zueinander entgegen gesetzte Richtungen weisen und auf die Schichten (9, 10) eine mechanische Vorspannung ausüben, ohne dass es zu einer Auslenkung des Biegebalkens kommt.

10. Verfahren nach Anspruch 9, wobei Spannungsimpulse an beidseits der piezoelektrischen Schichten (9, 10) angeordnete Elektrodenschichten angelegt werden.

11. Verfahren nach Anspruch 9 oder 10, wobei der Resonator (1) zu mechanischen Schwingungen angeregt und die Schwingungsenergie des Biegebalkens (2) in elektrische Energie umgeformt wird.

12. Verfahren nach Anspruch 11, wobei eine von der mechanischen Schwingung des Resonators (1) und/oder der erzeugten elektrischen Leistung abhängige physikalische Größe erfasst wird, und wobei die Feldstärken der elektrischen Felder derart eingestellt werden, dass die erfasste physikalische Größe ein Maximum aufweist.

## Claims

1. Tunable-frequency resonator (1), having a bending beam (2) which has at least one fixing point (3) and at least one deflection point (6) at a distance therefrom, the bending beam (2) being connected to at least one abutment (4) at the at least one fixing point (3) in such a way that the deflection point (6) can be moved in a deflection direction (8) arranged transversely with respect to the longitudinal extent (7) of the bending beam (2), with flexural deformation of the bending beam (2) relative to the at least one fixing point (3), the bending beam (2) having a piezoelectric layer (9) arranged transversely with respect to the deflection direction (8), and the resonator (1) having a control device (12) for applying an electric field to the layer (9), **characterized in that**, in addition to the first layer (9), the bending beam (2) has at least one second piezoelectric layer (10) arranged approximately parallel thereto, which is connected mechanically to the first layer (9) in such a way that the layers (9, 10) are stressed with respect to each other during deflection of the deflection point (6), and **in that**, with the aid of the control device (12), electric fields can be applied to the layers (9, 10) in such a way that piezoelectric forces are generated on the layers (9, 10), the actions of which point in mutually opposite directions as compensating bending moments and exert a mechanical preload on the layers (9, 10), and the bending beam in the neutral position is not deflected by the application of the electric fields.

2. Tunable-frequency resonator (1) according to Claim 1, **characterized in that** the piezoelectric layers (9, 10) are polarized in mutually opposite directions, and **in that** the control device (12) is configured in such a way that the electric field in the first layer (9) points in the opposite direction to the electric field in the second layer (10).

3. Tunable-frequency resonator (1) according to Claim 1, **characterized in that** the piezoelectric layers (9, 10) are polarized in the same direction, and **in that** the control device (12) is configured in such a way that the electric field in the first layer (9) points in the same direction as the electric field in the second layer (10).

4. Tunable-frequency resonator (1) according to one of Claims 1 to 3, **characterized in that** the control device (12) has an adjusting device for adjusting the field strength of the electric fields.

5. Tunable-frequency resonator (1) according to one of Claims 1 to 4, **characterized in that** the bending beam (2) has at least a first section (13) and a second section (14), which are arranged one after another in the longitudinal extent direction (7) of the bending beam (2), **in that** the piezoelectric layers (9, 10) are arranged only in the first section (13), and **in that** the second section (14) preferably has approximately the same flexural rigidity as the first section (13).

6. Tunable-frequency resonator (1) according to one of Claims 1 to 5, **characterized in that** the control device (12) has a pulse device for generating a pulsed electric field.

7. Device for producing electrical energy from a mechanical excitation vibration, having a tunable-frequency resonator (1) according to one of Claims 1 to 5, and having an electric generator (15) with a drive connection to the bending beam (2).

8. Device according to Claim 7, wherein the control device (12) has a control input (19) for the application of a control signal influencing the resonant frequency of the resonator (1), wherein the device has a sensor (20) for detecting the electric power output by the generator (15) and/or the deflection of the bending beam (2), and wherein the sensor (20) is connected to the control input (19) via a controller (21) in a control loop in such a way that the device is operated at an operating point at which the electric power output by the generator (15) exhibits a local maximum.

9. Method for operating a tunable-frequency resonator (1), wherein a bending beam (2) is provided which has at least two piezoelectric layers (9, 10) extending approximately parallel to each other and which are connected mechanically to each other, wherein the bending beam (2) is supported with respect to an abutment point at at least one fixing point (3) and, at a deflection point (6) at a distance from the fixing point (3), is caused to vibrate relative to the fixing point (3) transversely with respect to the planes of the piezoelectric layers (9, 10), in such a way that the layers (9, 10) are stressed with respect to each other, that electric fields are applied to the piezoelectric layers (9, 10), which are oriented and set with respect to their field strengths in such a way that they exert mechanical forces on the layers (9, 10), the actions of which point in mutually opposite directions as compensating bending moments and exert a mechanical preload on the layers (9, 10) without any deflection of the bending beam occurring.

10. Method according to Claim 9, wherein voltage pulses are applied to electrode layers arranged on both sides of the piezoelectric layers (9, 10).

11. Method according to Claim 9 or 10, wherein the resonator (1) is excited to make mechanical vibrations, and the vibratory energy of the bending beam (2) is transformed into electrical energy.

12. Method according to Claim 11, wherein a physical variable dependent on the mechanical vibration of the resonator (1) and/or the generated electric output is detected, and wherein the field strengths of the electric fields are set in such a way that the detected physical variable exhibits a maximum.

## Revendications

1. Résonateur (1) syntonisable en fréquence, avec un barreau flexible (2) qui comporte au moins une zone de fixation (3) et au moins une zone de déviation (6) écartée de celle-ci, sur l'au moins une zone de fixation (3), le barreau flexible (2) étant assemblé avec au moins une butée (4) de telle sorte que la zone de déviation (6) soit déplaçable dans une direction de déviation (8) placée à la transversale de l'extension longitudinale (7) du barreau de déviation (2), en déformant par flexion le barreau flexible (2) par rapport à l'au moins une zone de fixation (3), le barreau flexible (2) comportant une couche (9) piézoélectrique placée à la transversale de la direction de déviation (8) et le résonateur (1) comportant un dispositif d'amorçage (12) destiné à appliquer un champ électrique sur la couche (9), **caractérisé en ce qu'**en supplément de la première couche (9), le barreau flexible (2) comporte au moins une deuxième couche (10) piézoélectrique placée approximativement à la parallèle de cette dernière, qui est mécaniquement assemblée avec la première couche (9) de telle sorte que lors de la déviation de la zone de déviation (6), les couches (9, 10) se précontraignent l'une contre l'autre et **en ce qu'**à l'aide du dispositif d'amorçage (12) des champs électriques sont applicables sur les couches (9, 10) de telle sorte que des forces piézoélectriques soient créées sur les couches (9, 10) dont les effets sont dirigés en tant que des couples de flexion qui se compensent dans des directions mutuellement opposées et exercent sur les couches (9, 10) une précontrainte mécanique et le barreau flexible se trouvant dans la position neutre ne soit pas dévié par l'application des champs électriques.

2. Résonateur (1) syntonisable en fréquence selon la revendication 1, **caractérisé en ce que** les couches (9, 10) piézoélectriques sont polarisées dans des directions mutuellement opposées et **en ce que** le dispositif d'amorçage (12) est conçu de telle sorte que le champ électrique dans la première couche (9) soit dirigé dans la direction opposée à celle du champ électrique dans la deuxième couche (10).

3. Résonateur (1) syntonisable en fréquence selon la revendication 1, **caractérisé en ce que** les couches (9, 10) piézoélectriques sont polarisées dans la même direction et **en ce que** le dispositif d'amorçage (12) est conçu de telle sorte que le champ électrique dans la première couche (9) soit dirigé dans la même direction que le champ électrique dans la deuxième couche (10).

4. Résonateur (1) syntonisable en fréquence selon l'une quelconque des revendications 1 à 3, **caractérisé en ce que** le dispositif d'amorçage (12) comporte un dispositif d'ajustage pour ajuster l'intensité de champ des champs électriques.

5. Résonateur (1) syntonisable en fréquence selon l'une quelconque des revendications 1 à 4, **caractérisé en ce que** le barreau flexible (2) comporte au moins un premier segment (13) et un deuxième segment (14) qui dans la direction d'extension longitudinale (7) du barreau flexible (2) sont placés l'un derrière l'autre, **en ce que** les couches piézoélectriques (9, 10) ne sont placées que dans le premier segment (13) et **en ce que** le deuxième segment (14) fait preuve de préférence d'approximativement la même résistance à la flexion que le premier segment (13).

6. Résonateur (1) syntonisable en fréquence selon l'une quelconque des revendications 1 à 5, **caractérisé en ce que** le dispositif d'amorçage (12) comporte un dispositif d'impulsions pour créer un champ électrique pulsé.

7. Dispositif destiné à générer de l'énergie électrique à partir d'une oscillation d'excitation mécanique, avec un résonateur (1) syntonisable en fréquence selon l'une quelconque des revendications 1 à 5 et avec un générateur (15) électrique qui est en liaison d'entraînement avec le barreau flexible (2).

8. Dispositif selon la revendication 7, le dispositif d'amorçage (12) présentant une entrée de commande (19) destinée à appliquer un signal de commande influençant la fréquence de résonance du résonateur (1), le dispositif comportant un capteur (20) destiné à détecter la puissance électrique restituée par le générateur (15) et/ou la déviation du barreau flexible (2) et le capteur (20) étant connecté par l'intermédiaire d'un régulateur (21) avec l'entrée de commande (19) en un circuit de réglage, de telle sorte que le dispositif fonctionne en un point de fonctionnement sur lequel la puissance électrique restituée par le générateur (15) présente un maximum local.

9. Procédé destiné à faire fonctionner un résonateur (1) syntonisable en fréquence, un barreau flexible (2) étant mis à disposition, qui comporte au moins deux couches (9, 10) piézoélectriques s'étendant approximativement à la parallèle l'une de l'autre, qui sont mécaniquement assemblées l'une avec l'autre, le barreau flexible (2) étant appuyé sur au moins une zone de fixation (3) contre une zone de butée et sur un point de déviation (6) écarté du point de fixation (3), étant amené en oscillation par rapport à la zone de fixation (3), à la transversale des plans des couches (9, 10) piézoélectriques, de telle sorte que les couches (9, 10) se précontraignent l'une contre l'autre, que sur les couches (9, 10) piézoélectriques soient appliqués des champs électriques qui sont orientés et réglés au niveau de leur intensité de champ de sorte à exercer sur les couches (9, 10) des forces mécaniques dont les effets en tant que couples de flexion qui se compensent sont dirigés dans des directions mutuellement opposées et à exercer sur les couches (9, 10) une précontrainte mécanique sans donner lieu à une déviation du barreau flexible.

10. Procédé selon la revendication 9, les impulsions de tension étant appliquées à des couches d'électrodes placées de part et d'autre des couches piézoélectriques (9, 10).

11. Procédé selon la revendication 9 ou la revendication 10, le résonateur (1) étant excité en oscillations mécaniques et l'énergie oscillatoire du barreau flexible (2) étant transformée en énergie électrique.

12. Procédé selon la revendication 11, une grandeur physique dépendant de l'oscillation mécanique du résonateur (1) et/ou de la puissance électrique générée étant détectée et les intensités de champ des champs électriques étant réglées de telle sorte que la grandeur physique détectée présente un maximum.
